# EUROPEAN PATENT APPLICATION

(11) **EP 4 625 048 A1**
(43) Date of publication of application: **01.10.2025**
(21) Application number: 24167867.1
(22) Date of filing: 29.03.2024
(51) Int. Cl.: G03F 7/20, F16L 55/033

(54) **ACOUSTIC DAMPING DEVICE, FLUID TRANSPORT SYSTEM, TEMPERATURE CONDITIONING SYSTEM, AND LITHOGRAPHIC APPARATUS**

(71) Applicant: ASML Netherlands B.V., 5500 AH Veldhoven (NL)
(72) Inventor: REZAEIHA, Abdolrahim, 5500 AH Veldhoven (NL); DEMIREL, Ozan, Erdem, 5500 AH Veldhoven (NL); KRABBEN, Ingmar, Gerrit, Willem, 5500 AH Veldhoven (NL); VAN DE MEERENDONK, Remco, 5500 AH Veldhoven (NL); SCHAPENDONK, Markus, Josephus, Cornelis, 5500 AH Veldhoven (NL); BALARAJ, Vignesh, Srinivasan, 5500 AH Veldhoven (NL); OPRYSCHKO, Vladimir, 5500 AH Veldhoven (NL)
(74) Representative: ASML Netherlands B.V.

(57) **Abstract**

The invention provides an acoustic damping device, comprising:
an outer shell enclosing a flow channel having a first end to be connected to a liquid inlet and a second end to be connected to a liquid outlet, and
an inner tube arranged within the outer shell,

wherein a damping space is defined within the inner tube,
wherein the flow channel runs between the inner tube and the outer shell, and
wherein the inner tube is at least partially made of elastic or viscoelastic material to damp pressure waves in fluid flowing through the flow channel.

## Description

### FIELD

The present invention relates to an acoustic damping device. The invention further relates to a fluid transport system, a temperature conditioning system comprising such fluid transport system and a lithographic apparatus comprising such temperature conditioning system.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Generally, it is desirable to have a high throughput in a lithographic apparatus. To increase throughput in an EUV lithographic apparatus, the extreme ultraviolet (EUV) radiation should have also increased power. One of the challenges of higher EUV radiation power is that it will heat up and deform optical elements such as mirrors of the projection system. This deformation may cause imaging and overlay errors, generally referred to as lens or mirror heating errors.

To mitigate and/or reduce such lens or mirror heating errors, optical elements, such as mirrors, may be cooled directly using a temperature conditioning liquid, for example water, that is guided through temperature conditioning fluid lines in the respective optical element. Although this solution substantially improves temperature control of the optical elements, the temperature conditioning liquid may introduce acoustic noise into the optical elements due to pressure fluctuation generated from various sources. This acoustic noise may have a significant negative impact on performance of the optical elements and therewith on overlay performance. To reduce the acoustic noise the pressure fluctuations in the temperature conditioning liquid should be silenced before they reach the optical elements.

It has been proposed, to reduce the pressure fluctuations within the temperature conditioning liquid via gas silencers, also referred to as Helmholtz resonators. In such gas silencer gas, for example air, is used as a spring for a resonating mass of temperature conditioning liquid. A membrane may be arranged in the gas silencer to separate gas and cooling liquid from each other to avoid that gas is dissolved into cooling liquid over time.

Multiple of these gas silencers may be used in series in a temperature conditioning system. However, placement of the gas silencers may create low frequency pressure spikes due to the resonating mass of temperature conditioning liquid in the temperature conditioning system between two or more gas silencers. These low frequency pressure spikes may have a negative effect on the position accuracy of an optical element, in particular an optical element of which the position is not actively controlled. In addition, acoustic modes, i.e. standing waves, may be created within the temperature conditioning liquid conduits of the temperature conditioning system as well as in the gas silencer. This may result in undesired high frequency pressure spikes in the cooling liquid. These high frequency pressure spikes may also negatively influence performance of the optical element.

### SUMMARY

It is an object of an aspect of the invention to provide an acoustic damping device that can be used in a fluid transport system to damp low frequency pressure spikes and/or high frequency pressure spikes in fluid transported by the fluid transport system. In particular, it is an object of an aspect of the invention to damp low frequency pressure spikes and/or high frequency pressure spikes in temperature conditioning liquid of a temperature conditioning system for use in vacuum conditions.

According to an aspect of the invention there is provided an acoustic damping device, comprising:
an outer shell enclosing a flow channel having a first end to be connected to a liquid inlet and a second end to be connected to a liquid outlet, and
an inner tube arranged within the outer shell,

wherein a damping space is defined within the inner tube,
wherein the flow channel runs between the inner tube and the outer shell, and
wherein the inner tube is at least partially made of elastic or viscoelastic material to damp pressure waves in fluid flowing through the flow channel.

According to an aspect of the invention there is provided a fluid transport system, comprising an acoustic damping device, the acoustic damping device comprising:
an outer shell enclosing a flow channel having a first end to be connected to a liquid inlet and a second end to be connected to a liquid outlet, and
an inner tube arranged within the outer shell,

wherein a damping space is defined within the inner tube,
wherein the flow channel runs between the inner tube and the outer shell, and
wherein the inner tube is at least partially made of elastic or viscoelastic material to damp pressure waves in fluid flowing through the flow channel.

According to an aspect of the invention there is provided a temperature conditioning system for temperature conditioning of an object, the temperature conditioning system comprising the fluid transport system of any of the claims 15-20.

According to an aspect of the invention there is provided a lithographic apparatus comprising the temperature conditioning system of claim 21 for temperature conditioning of a component, such as an optical element of a projection system, substrate support, or patterning device support of the lithographic apparatus.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts schematically a temperature conditioning system, in particular a cooling system for an optical element in a lithographic apparatus;
- Figure 3 shows a gas silencer of the cooling system of Figure 2 in more detail;
- Figure 4 shows a first embodiment of a tubular acoustic damping device;
- Figure 5 shows a second embodiment of a tubular acoustic damping device;
- Figure 6 shows a first cross section A-A of the acoustic damping device of Figure 5; and
- Figure 7 shows a second cross section B-B of the acoustic damping device of Figure 5
- Figure 8 shows a third embodiment of a tubular acoustic damping device; and
- Figure 9 shows a configuration of a thermal conditioning system having a gas tube connected to damping spaces of acoustic damping devices.

### DETAILED DESCRIPTION

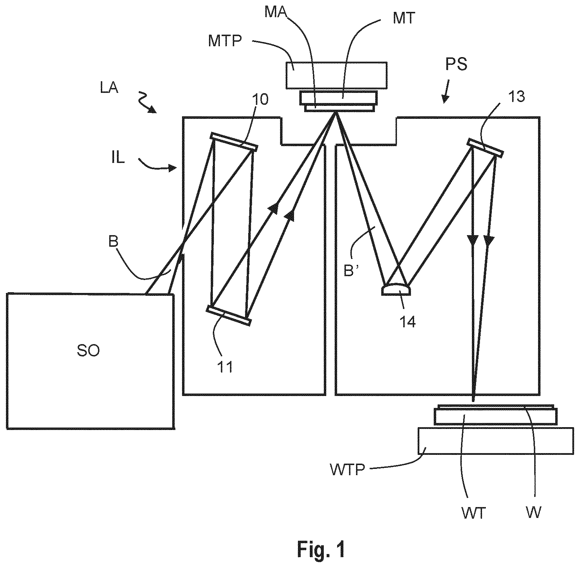

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of optical elements, such as mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

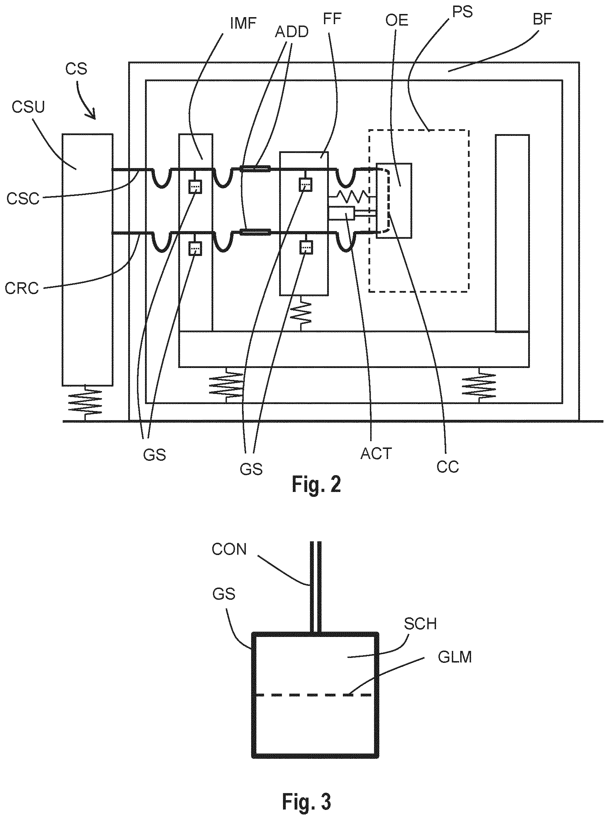

Figure 2 shows schematically a temperature conditioning system, in particular a cooling system CS for an optical element OE, for example a mirror, of a projection system PS of a lithographic apparatus, for instance the lithographic apparatus LA of Figure 1. In practice, the projection system PS may comprises multiple optical elements, such as multiple mirrors, but only one is shown in Figure 2. In alternative embodiments, the temperature conditioning system may be used for temperature conditioning of a frame, e.g. a force frame or a sensor frame, for temperature conditioning of a substrate support, e.g. substrate stage or a patterning device support, e.g. a patterning device support, and/or for temperature conditioning of air mounts, for example air mounts used to isolate a base frame from a metrology frame of a lithographic apparatus. Temperature conditioning may comprise heating and/or cooling of the respective object.

The lithographic apparatus comprises a base frame BF that delimits a vacuum environment, i.e. a closed space with a pressure well below atmospheric pressure. The base frame BF supports an intermediate frame IMF and the intermediate frame IMF supports a force frame FF. The optical element OE is supported by the force frame FF. In the shown embodiment, the position of the optical element OE is actively controlled using an actuator ACT arranged between the force frame FF and the optical element OE. The projection system PS may also comprise one or more optical elements of which the position is not actively controlled.

Due to the power of the EUV radiation that is used in the lithographic apparatus, there is a need to cool at least some of the optical elements OE of the lithographic apparatus. The cooling system CS provides cooling for the optical element OE by supplying a cooling liquid, for example cooling water, to the optical element OE. The cooling system CS comprises cooling system components, e.g. tanks, pumps, temperature control elements, etc. As there is limited space within the closed space delimited by the base frame BF, these cooling system components are placed outside the closed space, in this embodiment indicated as a cooling liquid supply unit CSU. The cooling liquid supply unit CSU is arranged to supply cooling liquid that is fed via a cooling liquid supply conduit CSC to the optical element OE. In the optical element OE the cooling liquid is guided through the cooling conduit CC. From the optical element OE, the cooling liquid may be returned to the cooling liquid supply unit CSU via a cooling liquid return conduit CRC. In practice, the components of the cooling liquid supply unit CSU do not have to be provided within a single unit, e.g. housing, but may also be provided as separate components arranged at suitable locations.

The cooling liquid supply conduit CSC and the cooling liquid return conduit CRC are guided via the base frame BF, the intermediate frame IMF and the force frame FF to the optical element OE. This creates a physical connection between these respective frames BF, IMF, FF and the optical element OE.

The frame construction is made to allow more vibrations in one frame compared to the other frame. In particular, the base frame BF is allowed to be subject to larger vibrations than the force frame FF and the optical element OE. The frames are isolated from each other by vibration damping device, such as air mounts and vibration controlled connections. However, the physical connection of the cooling liquid supply conduit CSC and the cooling liquid return conduit CRC between the respective frames BF, IMF, FF and the optical element OE may potentially result in the introduction of undesired vibrations from for example the base frame BF into the force frame FF or the optical element OE. These vibrations may be propagated through the materials and connections of the cooling liquid supply conduit CSC and the cooling liquid return conduit CRC, but also as pressure fluctuations within the cooling liquid.

To reduce the propagation of pressure fluctuations within the cooling liquid in the cooling liquid supply conduit CSC and the cooling liquid return conduit CRC, the cooling liquid supply conduit CSC and the cooling liquid return conduit CRC are provided with gas silencers GS, also referred to as Helmholtz resonators.

Figure 3 shows such gas silencer GS in more detail. The gas silencer GS comprises a silencer chamber SCH having a membrane GLM. The chamber part of the silencer chamber SCH above the membrane GLM contains cooling liquid and is connected by the connection conduit CON to one of the cooling liquid supply conduit CSC and the cooling liquid return conduit CRC. The chamber part of the silencer chamber SCH below the membrane GLM contains a gas. The gas, for example air, may work as a spring for a resonating mass of cooling liquid in the cooling liquid supply conduit CSC and/or the cooling liquid return conduit CRC connected via the connection conduit CON to the gas silencer GS.

Although the gas silencers GS may effectively reduce the pressure fluctuations in the cooling liquid supply conduit CSC and the cooling liquid return conduit CRC, the placement of the gas silencers GS may create low frequency pressure spikes, also referred to as sloshing, due to the resonating mass of cooling liquid in the cooling liquid supply conduit CSC and/or the cooling liquid return conduit CRC between two or more gas silencers GS. These low frequency pressure spikes could in particular have a negative effect on the position of passive optical elements, i.e. optical elements of which the position is not actively controlled.

Further, acoustic modes may be created in the cooling liquid supply conduit CSC and the cooling liquid return conduit CRC as well as in the silencer chamber SCH, which result in high frequency pressure spikes in the cooling liquid. These high frequency pressure spikes may also have a negative effect on the position accuracy of the optical elements OE, and as a result on the overlay performance of the lithographic apparatus LA.

Moreover, the membrane GLM separating gas and cooling liquid in the gas silencer GS could have structural resonances, which may couple with compliance of gas and hydraulic mass of the cooling liquid and may form a high-frequency pressure spikes in the cooling liquid.

To suppress the low frequency pressure spikes and the high frequency pressure spikes in the cooling liquid supply conduit CSC and/or the cooling liquid return conduit CRC tubular acoustic damping devices ADD may be provided in the cooling liquid supply conduit CSC and/or the cooling liquid return conduit CRC.

More generally, in a fluid line between a first gas silencer and a second gas silencer, a tubular acoustic damping device comprising a conduit made of elastic or viscoelastic material may be provided to damp low frequency pressure spikes due to a resonating mass of fluid in the fluid line between the first silencer and the second silencer, to damp acoustic modes within the fluid in the fluid line between the first gas silencer and the second gas silencer, and/or to damp acoustic modes within the fluid in the first gas silencer and/or the second gas silencer. The tubular acoustic damping device may also damp high-frequency pressure spikes in the cooling liquid resulting from structural resonances of the membrane GLM separating gas and cooling liquid in the gas silencer GS.

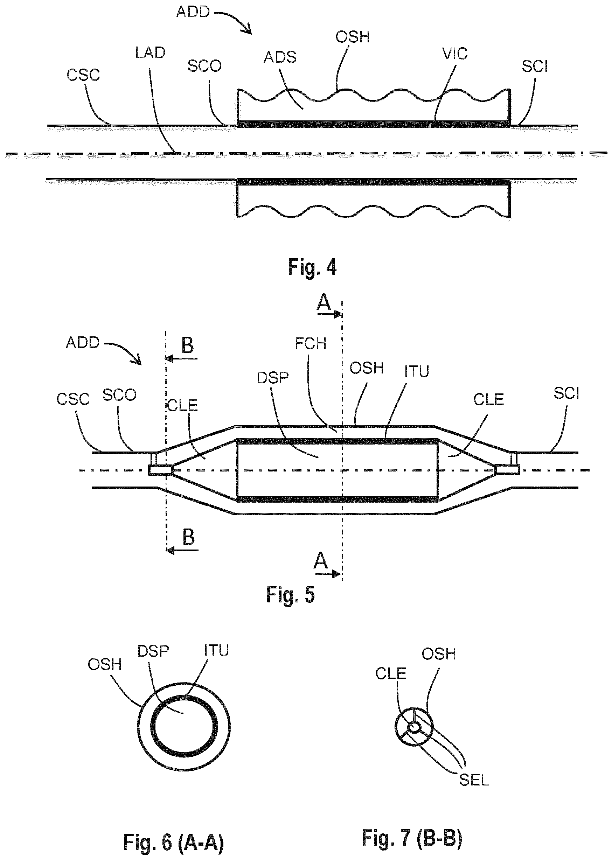

Figure 4 shows a first embodiment of such tubular acoustic damping devices ADD. The acoustic damping device ADD comprises an inner conduit VIC made of elastic or viscoelastic material. If the acoustic damping device ADD is provided in the cooling liquid supply conduit CSC, as shown in Figure 4, the inner conduit VIC has a first end connected to a liquid inlet SCI of a first part of the cooling liquid supply conduit CSC and a second end connected to a liquid outlet SCO of a second part the cooling liquid supply conduit CSC. Correspondingly, if the acoustic damping device ADD is provided in the cooling liquid return conduit CRC, the first end of the inner conduit VIC may be connected to a liquid inlet of a first part of the cooling liquid return conduit CRC and the second end may be connected to a liquid outlet of a second part the cooling liquid return conduit CRC. Thus, the inner conduit VIC forms a continuous liquid line with the first part and the second part of the cooling liquid supply conduit CSC or the cooling liquid return conduit CRC, respectively.

The elastic or viscoelastic material of the inner conduit VIC comprises for example at least one of a polytetrafluoroethylene, a polyurethane, a terpolymer comprising tetrafluoroethylene, hexafluoropropylene and vinylidene fluoride, a fluoroelastomer, other elastomers, such as PFAS-free elastomers, butyl rubber (IIR), chlorosulfonated polyethylene (CSM), epichlorohydrin rubber (ECO), polynorbonene rubber (PNR), ethylene-vinyl acetate rubber (EVA), acrylate rubber (ACM), ethylene propylene diene monomer (EPDM) and silicon.

The acoustic damping device ADD further comprises an outer shell OSH enclosing the inner conduit VIC. The outer shell OSH is made of an airtight material that is relatively rigid. As the outer shell OSH encloses the inner conduit VIC, the outer shell OSH ensures that the inner conduit VIC is not directly exposed to the influence of the vacuum environment in the closed space defined by the base frame BF. The outer shell OSH therefore make the acoustic damping device ADD suitable for application in a vacuum environment, i.e. a space having a pressure well below atmospheric pressure. The outer shell OSH can be made of a metal, for example stainless steel. The outer shell OSH may be corrugated.

An annular damping space ADS is formed between the inner conduit VIC and the outer shell OSH. This annular damping space ADS is used to allow the inner conduit VIC, in particular the elastic or viscoelastic material to deform, e.g. movement in radial direction, in dependence of the low frequency pressure spikes and/or the high frequency pressure spikes. The annular damping space ADS is filled with a gas, such as air, nitrogen or another suitable gas, to accommodate the deformation of the inner conduit VIC which results in a change of volume of the annular damping space ADS. The deformation of the elastic or viscoelastic material may therewith damp the low frequency pressure spikes and/or the high frequency pressure spikes.

In the shown embodiment of Figure 2, one acoustic damping device ADD is provided in a fluid line between two adjacent gas silencers. In alternative embodiments, two or more acoustic damping devices ADD may be provided in a fluid line between two adjacent gas silencers GS. The fluid transport system may comprises further gas silencers in series along one or more fluid lines. Tubular acoustic damping devices ADD may be provided in the one or more fluid lines between adjacent gas silencers such that conduits made of elastic or viscoelastic material of the tubular acoustic damping device are part of the one or more fluid lines.

The number of acoustic damping devices ADD, the lengths and diameters of the acoustic damping devices ADD, and the locations thereof, may be selected to provide a desired acoustic damping. The elastic or viscoelastic material of the acoustic damping devices ADD may be selected to have sufficient compliancy and damping property and to have sufficient structural strength.

Due to the presence of the acoustic damping devices ADD, the acoustic modes may be shifted to higher frequencies as the acoustic damping device ADD create new reflection points. By proper selection of the number, position and length of the acoustic damping devices ADD, the frequencies of the acoustic modes can be shifted out of frequency ranges of interest.

The acoustic damping devices ADD may also damp the acoustic modes by suppressing the peaks by dissipating the energy of the acoustic modes. Further, incoming pressure disturbances above a specific frequency, the so-called roll-off frequency, may be suppressed by the presence of the acoustic damping devices ADD due to a destructive interference above this roll-off frequency.

It has been found that if, in the embodiment of Figure 4, there is a temperature difference between the cooling liquid flowing through the inner conduit VIC and the environment outside the outer shell OSH, in particular when the temperature of the cooling liquid in the inner conduit VIC is higher than the environmental temperature, condensation of liquid on the inner surface of the outer shell OSH in the annular damping space ADS may occur. This liquid in the annular damping space ADS may be cooling liquid that permeated through the inner conduit VIC. As a result, the annular damping space ADS may fill with this cooling liquid and the acoustic damping effect of the acoustic damping device ADD may substantially decrease.

Figure 5 shows a second embodiment of an acoustic damping device ADD that avoids this effect. Figure 6 shows a first cross-section A-A of the acoustic damping device ADD of Figure 5. Figure 7 shows a second cross-section B-B of the acoustic damping device ADD of Figure 5.

The acoustic damping device ADD comprises an outer shell OSH enclosing a flow channel FCH having a first end to be connected to a liquid inlet SCI and a second end to be connected to a liquid outlet SCO. An inner tube ITU is arranged within the outer shell, wherein a damping space DSP is defined within the inner tube ITU. The flow channel FCH runs between the inner tube ITU and the outer shell OSH.

The outer shell OSH may be made of an airtight material that is relatively rigid. The outer shell OSH can for example be made of a metal, such as stainless steel. The outer shell OSH makes the acoustic damping device ADD suitable for application in a vacuum environment, i.e. a space having a pressure well below atmospheric pressure.

The inner tube ITU is at least partially made of elastic material or viscoelastic material, to damp pressure waves in fluid flowing through the flow channel FCH. The elastic or viscoelastic material of the inner tube ITU may comprise at least one of a polytetrafluoroethylene, a polyurethane, a terpolymer comprising tetrafluoroethylene, hexafluoropropylene and vinylidene fluoride, a fluoroelastomer, butyl rubber (IIR), chlorosulfonated polyethylene (CSM), epichlorohydrin rubber (ECO), polynorbonene rubber (PNR), ethylene-vinyl acetate rubber (EVA), acrylate rubber (ACM), ethylene propylene diene monomer (EPDM) and silicon. FKM (fluorocarbon-based fluoroelastomer materials) may be particularly suitable to be applied as viscoelastic material for the inner tube ITU.

The outer shell OSH and/or the inner tube ITU may be at least partially flexible, for example by having one or more corrugated sections to allow for tolerance compensation during the assembly of the acoustic damping device ADD in the liquid supply conduit CSC. In particular, the outer shell OSH may be made of relatively rigid material, such as stainless steel or another metal. By providing one or more corrugated sections or other flexible sections in the outer shell OSH, the outer shell OSH may be adapted to correct for mechanical tolerances, such as misalignment or incorrect length, between the connections to the fluid line, e.g. the liquid inlet SCI and liquid outlet SCO.

In the embodiment of Figure 5, the damping space DSP is a closed damping space filled with a compressible fluid and/or compressible damping material or structure. The compressible fluid is for example a gas, such as air. The provision of a compressible damping material or structure may have the advantage that this material or structure prevents that the inner tube ITU collapses in case of a substantial larger pressure in the flow channel FCH than in the damping space DSP. The compressible damping material is for example a foam material and the compressible damping structure is for example a construction with springs that can be compressed in radial direction.

To create the closed damping space DSP, the inner tube ITU may be closed at its opposite ends. In the embodiment of Figure 5, the inner tube ITU comprises closure elements CLE to close the inner tube ITU at its opposite ends. The closure elements CLE are sealed with a leaktight seal to the respective end of the inner tube ITU. The sealing may for example be realized by clamping, vulcanization, gluing or any other method with metal, rubber, or other suitable material.

As can be seen in Figure 6, the flow channel FCH formed between the inner tube ITU and the outer shell OSH has an annular cross-section. The flow of cooling liquid is directly along the outer shell OSH and the temperature within the damping space DSP will be substantially the same as the temperature of the cooling liquid.

By providing the damping space DSP within the inner tube ITU and the cooling liquid flow in an annular space between the inner tube ITU and the outer shell OSH, an isothermal effect is obtained between the cooling liquid and the damping space DSP. This means that, in steady state, there is substantially no temperature difference between the cooling liquid and the damping space DSP as the temperature within the damping space DSP is determined by the temperature of the cooling liquid in the cooling liquid flow. As a result, the occurrence of condensation on an inner wall of the damping space DSP is avoided.

The closure elements CLE are positioned in the flow channel FCH and configured to guide the flow of cooling liquid from a central flow with circular cross-section into a flow around the inner tube ITU in the annular flow channel FCH. It is desirable that these closure elements CLE do not introduce additional acoustic vibrations in the cooling liquid. By a suitable design of the closure elements CLE, such as a cone shape, the creation of flow induced vibrations at the closure elements CLE may be prevented or at least substantially reduced.

The acoustic damping device ADD comprises support elements SEL between the outer shell OSH and the inner tube ITU to hold the inner tube ITU in a desired position, for example a centered position with respect to the outer shell OSH. In the embodiment shown in Figure 5 the support elements SEL are arranged at the outer ends of the closure elements CLE of the inner tube ITU. In alternative embodiments, the support element SEL may also be arranged at any other suitable location.

The support elements SEL are arranged in the flow of the cooling liquid. To prevent or reduce creation of flow induced vibrations at the support elements SEL the support elements SEL are, similar to the closure elements CLE designed to avoid or minimize creation of flow induced vibrations at the support elements SEL. The support elements SEL may for example be relatively thin plate shaped or fin shaped elements, wherein the plate shaped or fin shaped elements are aligned with a flow direction of the flow of cooling liquid to minimize flow resistance.

Further, the support elements SEL may be designed to have a low thermal conductivity. To prevent cold spots on or in the inner tube ITU that in their turn may lead to condensation in the damping space DSP, the thermal conductivity of the support elements SEL may be made relative low. The support elements SEL may for example partially be made of thermally insulating material.

The surface area of the annular cross section of the flow channel FCH between the inner tube ITU and the outer shell OSH may substantially correspond with a surface area of a cross section of the flow channel FCH at the first end and/or second end of the acoustic damping device ADD. As a result, the speed of the cooling liquid through the acoustic damping device ADD will remain substantially the same over the length of the acoustic damping device ADD.

Figure 6 shows a third embodiment of an acoustic damping device ADD. In the embodiment of Figure 5, the inner tube ITU comprises a closed damping space DSP that is completely sealed. The complete sealing can be created during fabrication of the inner tube ITU.

In the embodiment of Figure 6, a gas tube GTU runs through the damping space DSP. The interior of the gas tube GTU is fluidly connected to the damping space DSP. The gas tube GTU can be connected to a gas conditioning device that may control the pressure of the gas, for example air, that is guided through the gas tube GTU. By controlling the pressure in the gas tube GTU also the pressure in the damping space DSP may be controlled. This may be useful for example to create a pressure equilibrium between the liquid pressure in the flow channel FCH and the gas pressure in the damping space DSP, i.e. a pressure equilibrium between interior and exterior of the inner tube ITU. Such pressure equilibrium or at least the possibility to control the pressure in the damping space DSP may be beneficial to control the expansion or compression of the inner tube ITU. Too large expansion of the inner tube ITU may lead to blockage of the flow channel FCH, while too large compression may lead to a collapsing of the inner tube ITU.

The gas tube GTU may be connected to a two or more acoustic damping devices ADD that are arranged in the fluid line of the cooling system CS to control the pressure in the respective damping spaces DSP of the two or more acoustic damping devices ADD.

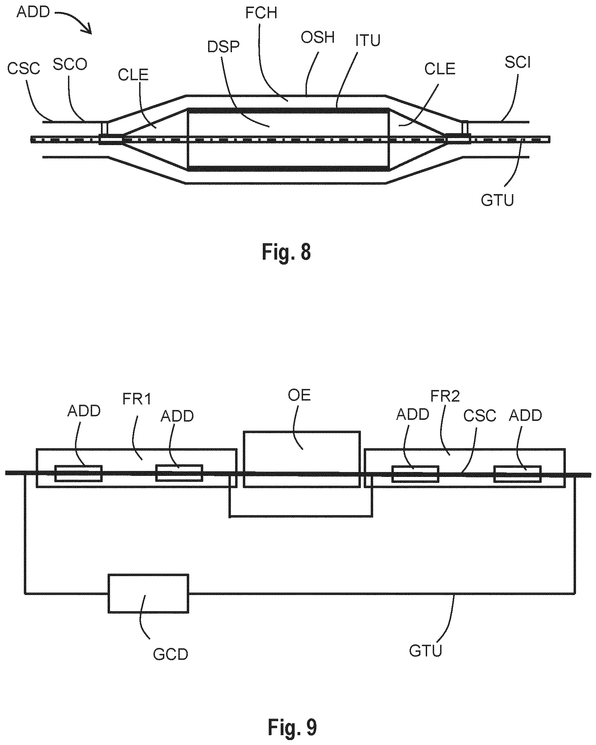

Figure 9 shows a configuration wherein a gas tube GTU is connected with a gas conditioning device GCD and four acoustic damping devices ADD arranged in a cooling system conduit CSC of a cooling system CS. The gas tube GTU runs through a number of parts of the cooling system conduit CSC, indicated in Figure 9 by a first frame FR1 and a second frame FR2, but not where the cooling system conduit CSC runs through the optical element OE, i.e. the critical element in the cooling system CS. In the embodiment shown in Figure 9, the gas tube GTU forms a bypass with respect to the optical element OE.

In alternative embodiments, there may be provided multiple parallel gas conduits GTU. For example, a first gas tube GTU that runs through the cooling system conduit CSC in the first frame FR1 and a second gas tube GTU that runs through the cooling system conduit CSC in the second frame FR2.

Further, in the shown embodiments, the acoustic damping devices ADD are shown as having a relatively small length. In practice, the acoustic damping devices ADD may extend over a longer length. For example, in an embodiment a substantial part of the cooling system conduit CSC of a cooling system CS may be formed by an outer shell OSH and an inner tube ITU, that form an inner damping space DSP within the inner tube ITU and an annular flow channel FCH between the inner tube ITU and the outer shell OSH. Such substantial part may for example be a part of the cooling system conduit CSC running through a frame part or other component of a lithographic apparatus. In such embodiment, the inner tube may also function as gas tube GTU.

The acoustic damping devices ADD as shown in Figures 5 and 9 may also be applied in a fluid transport system without gas silencers to damp acoustic vibrations.

Hereinabove, a cooling system is described for cooling of an object using a cooling liquid. Such cooling system is a temperature conditioning system that is configured to condition the temperature of an object by cooling using a temperature conditioning liquid. In other embodiments, a temperature conditioning system can also be used to condition a temperature of an object by heating or by a combination of heating and cooling using the temperature conditioning liquid. All embodiments, described herein may also be used for heating (negative cooling) or a combination of heating and cooling. The combination of gas silencers and acoustic damping devices can advantageously be used to damp low frequency pressure spikes and/or high frequency pressure spikes in the temperature conditioning liquid of the temperature conditioning system.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories second, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An acoustic damping device, comprising:
an outer shell enclosing a flow channel having a first end to be connected to a liquid inlet and a second end to be connected to a liquid outlet, and
an inner tube arranged within the outer shell,
wherein a damping space is defined within the inner tube,
wherein the flow channel runs between the inner tube and the outer shell, and
wherein the inner tube is at least partially made of elastic or viscoeleastic material to damp pressure waves in fluid flowing through the flow channel.

2. The acoustic damping device of claim 1, wherein the damping space is a closed damping space filled with a compressible fluid and/or compressible damping material.

3. The acoustic damping device of claim 2, wherein the inner tube is closed at its opposite ends to create the closed damping space.

4. The acoustic damping device of claim 3, wherein the inner tube comprises closure elements to close the inner tube at opposite ends.

5. The acoustic damping device of claim 4, wherein the closure elements are shaped to avoid or minimize creation of flow induced vibrations at the closure elements.

6. The acoustic damping device of any of the claims 1-5, wherein the acoustic damping device comprises one or more support elements between the outer shell and the inner tube to hold the inner tube in a desired position, for example a centered position, with respect to the outer shell.

7. The acoustic damping device of claim 6, wherein the support elements have a low thermal conductivity.

8. The acoustic damping device of claim 6 or 7, wherein the support elements are shaped to avoid or minimize creation of flow induced vibrations at the support elements.

9. The acoustic damping device of any of the claims 1-8, wherein the flow channel between the inner tube and the outer shell comprises an annular cross section.

10. The acoustic damping device of claim 9, wherein a surface area of the annular cross section of the flow channel between the inner tube and the outer shell substantially corresponds with a surface area of a cross section of the flow channel at the first end and/or second end.

11. The acoustic damping device of any of the claims 1-10, wherein the inner tube is configured for use in a vacuum environment.

12. The acoustic damping device of any of the claims 1-11, wherein the viscoelastic material comprises at least one of:
a polytetrafluoroethylene,
a polyurethane,
a terpolymer comprising tetrafluoroethylene, hexafluoropropylene and vinylidene fluoride,
a fluoroelastomer, for example fluorocarbon-based fluoroelastomer materials (FKM),
butyl rubber (IIR),
chlorosulfonated polyethylene (CSM),
epichlorohydrin rubber (ECO),
polynorbonene rubber (PNR),
ethylene-vinyl acetate rubber (EVA),
acrylate rubber (ACM),
ethylene propylene diene monomer (EPDM), and
silicon.

13. The tubular acoustic damping device of any of the claims 1-12, wherein the outer shell is at least partially flexible, for example by comprising one or more corrugated sections.

14. The tubular acoustic damping device of any of the claims 1-13, wherein the outer shell is made of a rigid material, such as a metal, for example stainless steel.

15. A fluid transport system, comprising the tubular acoustic damping device of any of the preceding claims.

16. The fluid transport system of claim 15, wherein the fluid transport system further comprises:
a first gas silencer, and
a second gas silencer,
wherein the first gas silencer and the second gas silencer are fluidly connected to each other by a fluid line, wherein the tubular acoustic damping device is provided in the fluid line between the first gas silencer and the second gas silencer such that the flow channel of the tubular acoustic damping device is a part of the fluid line.

17. The fluid transport system of claim 15 or 16, wherein the fluid transport system is configured to transport temperature conditioning fluid, for example temperature conditioning liquid, of a temperature conditioning system for temperature conditioning of an object.

18. The fluid transport system of any of the claims 15-17, wherein the fluid transport system comprises further gas silencers in series along one or more fluid lines, wherein tubular acoustic damping devices are provided in the one or more fluid lines between adjacent further gas silencers such that flow channels of the tubular acoustic damping devices are part of the one or more fluid lines.

19. The fluid transport system of any of the claims 15-18, wherein the fluid transport system comprises a gas tube connected to the damping space of at least one acoustic damping device and connected to a gas conditioning device configured to control the gas pressure of the gas in the gas tube.

20. The fluid transport system of any of the claims 15-18, wherein the gas tube runs at least partially through the fluid line of the fluid transport system.

21. A temperature conditioning system for temperature conditioning of an object, the temperature conditioning system comprising the fluid transport system of any of the claims 15-20.

22. A lithographic apparatus comprising a temperature conditioning system as claimed in the preceding claim for temperature conditioning of a component, such as an optical element of a projection system, substrate support, or patterning device support of the lithographic apparatus.
